# EUROPEAN PATENT SPECIFICATION

(11) **EP 2 764 763 B1**
(45) Date of publication and mention of the grant of the patent: **27.09.2017**
(21) Application number: 11873687.5
(22) Date of filing: 05.10.2011
(51) Int. Cl.: H01L 31/052

(54) **NANOPLASMONIC DEVICE WITH NANOSCALE COOLING**
NANOPLASMONENVORRICHTUNG MIT NANOSKALIGER KÜHLUNG
DISPOSITIF NANOPLASMONIQUE À REFROIDISSEMENT À NANO-ÉCHELLE

(43) Date of publication of application: 13.08.2014
(73) Proprietor: Sabanci Üniversitesi, 34956 Istanbul (TR); Özyegin Üniversitesi, 34662 Altunizade, Istanbul (TR)
(72) Inventor: SENDUR, Ibrahim Kursat, 34956 Orhanli-Tuzla Istanbul (TR); KOSAR, Ali, 34956 Orhanli-Tuzla Istanbul (TR); MENGUC, Mustafa Pinar, 34662 Altunizade Istalbul (TR)
(74) Representative: Sevinç, Erkan
(86) International application number: PCT/US2011/054929
(87) International publication number: WO 2013/052045

(56) References cited:
- WO-A2-2008/153686
- US-A1- 2005 116 336
- US-A1- 2005 126 766
- KURSAT SENDUR ET AL: "Improving the Near-Field Transmission Efficiency of Nano-Optical Transducers by Tailoring the Near-Field Sample", MRS PROCEEDINGS, vol. 1182, 1 January 2009 (2009-01-01), XP055188804, DOI: 10.1557/PROC-1182-EE13-41
- ONUKI T ET AL: "Radiative cooling using plasmon resonant nanostrips", NANO/MICRO ENGINEERED AND MOLECULAR SYSTEMS (NEMS), 2010 5TH IEEE INTERNATIONAL CONFERENCE ON, IEEE, PISCATAWAY, NJ, USA, 20 January 2010 (2010-01-20), pages 409-412, XP031918322, DOI: 10.1109/NEMS.2010.5592419 ISBN: 978-1-4244-6543-9
- JACOB B KHURGIN ED - D-C WU ET AL: "Surface plasmon assisted laser cooling of solids", CLEO '07. 2007 CONFERENCE ON LASERS AND ELECTRO-OPTICS 5-11 MAY 2007 BALTIMORE, MD, USA, OSA, PISCATAWAY, NJ, USA, 1 May 2007 (2007-05-01), pages 1-2, XP031203418, ISBN: 978-1-55752-834-6

## Description

### BACKGROUND OF THE INVENTION

The present invention relates to nanoplasmonic devices and, in particular, to the cooling of nanoplasmonic devices.

Nanoplasmonic techniques are being used increasingly to couple optical energy into devices. Examples of such applications include magnetic memory, photovoltaic cells, and sub-wavelength lithography. Besides efficient coupling of the energy, sub-wavelength resolutions are possible.

Such applications make use of an optical spot smaller than the diffraction limit. This can result in substantial localized heating. Heat can be removed with a bulk metallic layer, see KURSAT SENDUR ET AL: "Improving the Near-Field Transmission Efficiency of Nano-Optical Transducers by Tailoring the Near-Field Sample",MRS PROCEEDINGS, vol. 1182, 1 January 2009 (2009-01-01), XP055188804, but this can result in general heating by spreading the heat and may as well change the near-field characteristics of the device. In general, it may be difficult to obtain satisfactory cooling in an efficient and compact manner.

### SUMMERY OF THE INVENTION

A nanoplasmonic device in accordance with the invention includes i.a. a nanoplasmonicly heatable layer having a heating side and a cooling side, the heatable layer including a plurality of localized energy receiving sites; and a cooling structure located adjacent to the cooling side, the cooling structure including a nanoscale structure to remove heat from the heated layer. The invention is defined more closely in claim 1.

### BRIEF DESCRIPTION OF THE DRAWINGS

FIG. 1 is a schematic diagram of an example of a nanoplasmonic system according to an aspect of the invention;
FIG. 2 is a schematic diagram of an example of a nanoplasmonic device according to another aspect of the invention;
FIG. 3 is a schematic diagram of an example of a nanoplasmonic device according to an additional aspect of the invention; and
FIG. 4 is a schematic diagram of an example of a nanoplasmonic device related to the invention.

### DESCRIPTION OF THE PREFERRED EMBODIMENTS

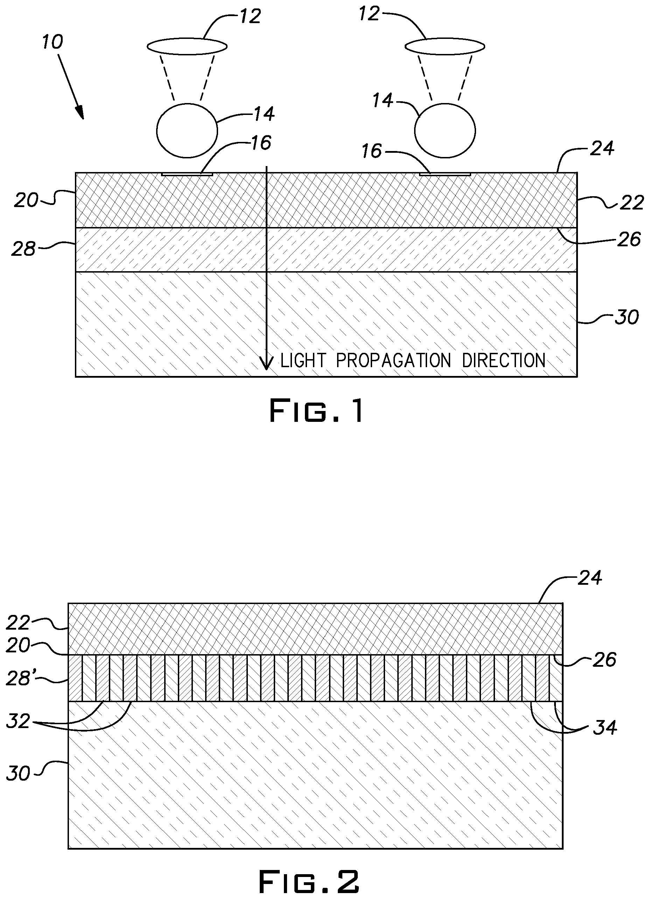

Referring to FIG. 1, an example nanoplasmonic system 10 includes optical sources 12, nanotransducers 14, and a nanoplasmonic device 20.

The nanoplasmonic device 20 includes a heatable layer 22 having a heating side 24 and a cooling side 26 and a cooling structure 28 adjacent to the cooling side 26. The cooling structure 28 includes nanostructures described more fully below.

The heatable layer 22 may be, for example, a magnetic memory material responsive to heat, a photovoltaic cell, or a lithography material.

In operation, each optical source 12 and nanotransducer 14 combination can produce a sub-wavelength spot 16 of optical energy on the heatable layer 22. The nanotransducers 14 may be, for example, known devices for localizing incident raciation into a sub-wavelength heated spots such as nanoparticles, nanoantennas and nanowaveguides. Each spot 16 corresponds to a localized energy receiving site. It would also be possible to translate a single optical source 12 and nanotransducer 14 combination to successively illuminate the spots 16. Radiative heat transfer at the nanoscale is the fundamental mechanism in coupling the sub-wavelength optical spots 16 produced by each optical spot 12 and nanotransducer 16 combination.

When two objects are not in contact, i.e. when these two objects are separated by a distance, there is still a heat transfer between objects due to radiative heat transfer. The heat is transferred between these two bodies through electromagnetic radiation. Classically, this electromagnetic radiation from an object is related to the temperature of the object, and is known as the blackbody radiation. The electrcmagnetic radiative heat transfer from an object to another object not only depends on the temperature of the radiator, but also other factors as well, including the distance between two objects. Electromagnetic radiation from an object scales with 1/R, where R is the distance from the object. The electromagnetic power scales with 1/R^2.

However, at the nanoscale, that is, the sub-wavelength scale, when objects are separated by less than sub-wavelength scale, the radiative heat transfer between the surfaces can be several orders of magnitude higher than predicted by Planck's blackbody radiation. The radiative heat transfer at sub-wavelength distances can be three orders of magnitude higher than the prediction by Planck's blackbody radiation. This enhancement is due to electromagnetic energy tunneling of the evanescent fields, and excitation of surface plasmon or phonon polaritons on the structures. There are several ways to enhance this radiative heat transfer between objects. When the objects are brought into the sub-wavelength near-field regime, the radiative energy transfer between objects is enhanced due to evanescent coupling of the electromagnetic energy between objects. This phenomenon is also referred to as photon tunneling, and it is observed if the objects are separated by less than the wavelength of light. In addition, surface plasmon resonances or phonon resonances also improve the electromagnetic energy transfer. If the structures support surface plasmon resonances or surface phonon resonances, the electromagnetic energy transfer substantially increase. As used herein, plasmonic cooling or phononic cooling correspond to cooling an object through enhanced energy transfer when one or more of the structures supports surface plasmon resonances or surface phononic resonances, respectively.

While the space or gap between objects may be, for example, air or vacuum, material such as dielectrics may also be used.

Referring to FIG. 2, the nanoplasmonic device 20 includes a heatable layer 22 and a cooling structure 28' formed on a substrate 30. The substrate may be for example a semiconductor or dielectric material such as silicon or any other suitable material such as ceramic glass or amorphous glass and is generally much thicker than the other layers. The heatable layer may be, for example, 5 nm to 30 nm thick. The cooling structure 28' may be, for example, 5 nm to 200 nm thick.

The cooling structure 28' is formed from a dielectric or semiconductor 32 with embedded nanoparticles 34 that support surface plasmon or phonon resonance.

The size of the nanoparticles 34 can be between 5 nm and 200 nm. It is expected that particle sizes on the order of 5 nm to 20 nm is preferable. The alternating pattern of particles as a percentage of total width can be referred to as the duty cycle. A typical duty cycle for the particles is around 50 percent.

The dielectric 32 can be, for example, an oxide such as silicon dioxide, titanium dioxide, or tantulum pentoxide. The nanoparticles 32 can be made of metals such as gold, silver, aluminum, platinum, or copper to support surface plasmon resonances. Alternatively, the nanoparticles 32 can be made of SiC, cubic boron nitride (cBN), hexagonal boron nitride (hBN), or boron carbide BC to support surface phonon resonances.

These structures can be fabricated using different techniques. One potential way to fabricate these structures is the thin-film deposition and patterning techniques, which are well-known and heavily utilized by semiconductor companies and hard-disk drive companies. Thin film layers can be deposited using different techniques such as sputtering, thermal evaporation, or ion beam deposition. The patterning of these structures can be achieved using photolithographic techniques. Alternatively, patterning of these structures can also be achieved using more recently developed techniques including self-ordered arrays or nanoimprint lithography.

Different patterns can be made of nanoparticles embedded into a dielectric or semiconductor layer. Different patterns can be obtained by using different duty-cycles between particles. Also, different patterns include the possible shapes that can form the cross section of the layer. Different patterns can refer to different cross sections of nanoparticles, including, for example, spherical, cylindrical, rectangular and square. Different patterns can also refer to different arrangements of these particles with respect to each other, including regular distribution with constant duty-cycle and random distribution.

This utilizes the coupling between fundamental electromagnetic and thermal phenomena. Placing patterned structures that can support surface plasmon resonances and phonon resonances improve the localized electromagnetic and optical field distribution around these regions. Such localized and improved optical fields improve the radiative energy transfer between these particles and the heatable layer thereby improving the localized heating and cooling.

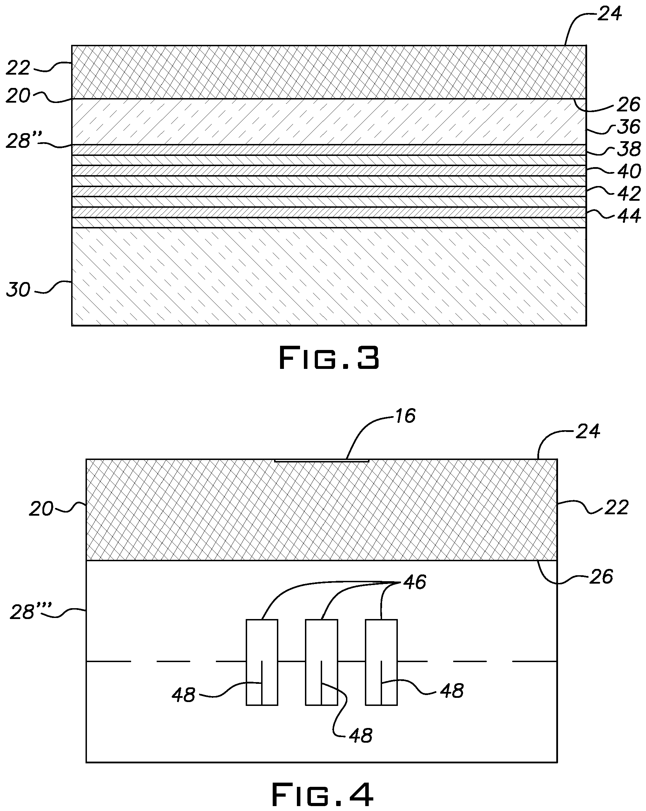

Referring to FIG. 3, the nanoplasmonic device 20 includes a heatable layer 22 and a cooling structure 28" formed on a substrate 30. The substrate may be for example a semiconductor or dielectric material such as silicon or any other suitable material such as ceramic glass or amorphous glass and is generally much thicker than the other layers. The heatable layer may be, for example, 5 nm to 30 nm thick. The cooling structure 28'' may be, for example, 5 nm to 200 nm thick.

The cooling structure 28" includes a gap 36 between the heatable layer 22 and the polariton layers 38, 40, 42, 44. The gap 36 facilitates the radiative energy transfer between the layers. This gap should be very small, i.e. nanoscale scale or sub-wavelength scale, to facilitate phonon tunneling (or evanescent energy coupling) between the structures. The layer underneath is selected so that it supports surface phonon resonances or alternatively it can be selected to support surface plasmon resonances. This way the radiative energy transfer between the objects is further enhanced.

The polariton layers 38, 40, 42, 44 are a multilayer structure, where each layer may have a different thickness and material property. Each layer may have a different property from the other. The stack supports surface plasmon resonances or surface phonon resonances. These are surface waves that can be excited under specific conditions. The layers can be surface plasmon resonance supporting metals such as gold or silver; or surface phonon resonance materials such as SiC, cubic boron nitride (cBN), hexagonal boron nitride (hBN), or boron carbide BC. In between the layers are dielectric layers.

Referring to FIG. 4, the nanoplasmonic device 20 includes a heatable layer 22 and a cooling structure 28"' formed in the substrate 30.

The cooling structure 28"' includes sub-micron channels 46 in the substrate 30 for use with a circulating cooling fluid, for example, water. Inside of each channel 46 are nanorods 48 to improve heat absorption by the cooling fluid. Shapes other than rods could also be employed.

The cooling structure 28"' may be, for example fabricated in a silicon substrate. The substrate 30 can be formed from two halves anodically bonded together and similarly bonded to the heatable layer 22. E-beam lithography techniques can be used to form the channels in each half. Before bonding, the nanostructures can be deposited by glancing angle deposition (GLAD). The nanostructures can be rods of copper for example.

It should be noted that the cooling structure 28"' is localized sunder the spot 16. This localization can be employed in the other embodiments herein as well. This allows not only the more rapid cooling possible with nanoscale structures, but also the focusing of the cooling effects more closely to where they are needed.

It should be evident that this disclosure is by way of example and that various changes may be made by adding, modifying or eliminating details without departing from the fair scope of the teaching contained in this disclosure. The invention is therefore not limited to particular details of this disclosure except to the extent that the following claims are necessarily so limited.

## Claims

1. A nanoplasmonic device (10, 20) formed on a substrate (30), the nanoplasmonic device comprising:
a nanoplasmonically heatable layer (22) having a heating side (24) and a cooling side (26), said heatable layer including a plurality of localized energy receiving sites, each localized energy receiving site suitable for receiving energy from corresponding sub-wavelength spots (16) of an optical field producible on the heatable layer (22); and
a cooling structure (28', 28") for removing heat from said heatable layer (22), said cooling structure being located adjacent to said cooling side (26) and being sandwiched between the nanoplasmonically heatable layer (26) and the substrate (30),
**characterized in that**
the cooling structure (28', 28") is formed from a dielectric or semiconductor material (32) with embedded nanoparticles (34) that support surface plasmon or phonon resonances, or
the cooling structure (28', 28") comprises a multilayer structure including one of a vacuum gap, an air gap or a dielectric layer (36), the gap or dielectric layer being arranged adjacent the heatable layer (22) for facilitating phonon tunneling or evanescent energy coupling and
followed by a layer (38) supporting surface phonon resonances or surface plasmon resonances.

2. A nanoplasmonic device (10, 20) according to claim 1, wherein said cooling structure (28', 28") is formed from a dielectric or semiconductor material with embedded nanoparticles comprising longitudinally alternating nanoparticle and non-nanoparticle regions.

3. A nanoplasmonic device (10, 20) according to claim 1, wherein the dielectric or semiconductor material (32) of said cooling structure (28', 28") is formed from a dielectric or semiconductor material with embedded nanoparticles are made of an oxide such as silicon dioxide, titanium dioxide or tantalum pentoxide.

4. A nanoplasmonic device (10, 20) according to the claim 1, wherein the nanoparticles (34) of said cooling structure (28', 28") are formed from a dielectric or semiconductor material with embedded nanoparticles made of gold, silver, aluminum, platinum or copper to support surface plasmon resonances or made of SiC, cubic boron nitride, hexagonal boron nitride or boron carbide to support surface phonon resonances.

5. A nanoplasmonic device (10, 20) according to the claim 1, wherein the layer (38) supporting surface phonon resonances or surface plasmon resonances is part of a stack (38, 40, 42, 44) supporting surface plasmon resonances or surface phonon resonances.

6. A nanoplasmonic device (10, 20) according to the claim 5, wherein the layers of said stack (38, 40, 42 , 44) are made of a surface plasmon resonance supporting metal, or made of a phonon resonance supporting material, and said layers being separated by dielectric layers.

7. A nanoplasmonic device according to the claim 6, wherein the surface plasmon resonance supporting metal is selected from gold or silver, and/or the phonon resonance supporting material is selected from SiC, cubic boron nitride, hexagonal boron nitride or boron carbide.

8. A nanoplasmonic device according to any of the claims 1 to 7, wherein the thickness the heatable layer (22) is within the range between 5 nm and 30 nm.

9. A nanoplasmonic device according to any of the claims 1 to 8, wherein the thickness the cooling structure (28, 28') is within the range between 5 nm and 200 nm.

10. A nanoplasmonic device according to the claim 1, comprisinga plasmonic cooling layer and the plasmonic cooling layer comprises a gap layer of less than a sub-wavelength thickness and a plasmonic sub-layer, or comprising a phononic cooling layer and the phononic cooling layer comprises a gap layer of less than a sub-wavelength thickness and a plasmonic sub-layer.

11. A nanoplasmonic device according to claim 10, wherein said plasmonic cooling layer comprises alternating gap layers and plasmonic sub-layers, or said phononic cooling layer comprises alternating gap layers and phononic sub-layers.

12. A nanoplasmonic device according to claim 1, wherein said cooling structure comprises a phononic cooling layer and the phononic cooling layer comprises longitudinally alternating nanoparticle and non-nanoparticle regions.

13. A nanoplasmonic device according to claim 1, wherein said cooling structure is localized to said localized energy receiving sites.

14. A nanoplasmonic device according to claim 1, wherein said device is one of a data storage device, a photovoltaic cell and a lithography medium.

## Patentansprüche

1. Nanoplasmonische Vorrichtung (10, 20), die auf einem Substrat (30) gebildet ist, wobei die nanoplasmonische Vorrichtung umfasst:
eine nanoplasmonisch erwärmbare Schicht (22) mit einer Erwärmungsseite (24) und einer Kühlungsseite (26), wobei die erwärmbare Schicht eine Vielzahl von lokalisierten Energieaufnahmestellen einschließt, wobei jede lokalisierte Energieaufnahmestelle zum Aufnehmen von Energie aus korrespondierenden Unterwellenlängenflecken (16) eines optischen Feldes geeignet ist, das auf der erwärmbaren Schicht (229 herstellbar ist; und
eine Kühlungsstruktur (28', 28") zum Entfernen von Wärme von der erwärmbaren Schicht (22), wobei die Kühlungsstruktur angrenzend an die Kühlungsseite (26) angeordnet ist und sandwichartig zwischen der nanoplasmonisch erwärmbaren Schicht (26) und dem Substrat (30) ist, **dadurch gekennzeichnet, dass** die Kühlungsstruktur (28', 28") aus einem dielektrischen oder Halbleitermaterial (32) mit eingebetteten Nanoteilchen (34) gebildet ist, die Oberflächenplasmon- oder - Phononresonanzen tragen, oder
die Kühlungsstruktur (28', 28") eine Mehrschichtstruktur umfasst, einschließend eines eines Vakuumspalts, eines Luftspalts oder einer dielektrischen Schicht (36), wobei der Spalt oder die dielektrische Schicht angrenzend an die erwärmbare Schicht (22) zum Erleichtern eines Phononentunnelns oder einer abklingenden Energiekopplung angeordnet ist und
gefolgt von einer Schicht (38), die Oberflächenphononresonanzen oder Oberflächenplasmonresonanzen trägt.

2. Nanoplasmonische Vorrichtung (10, 20) nach Anspruch 1, wobei die Kühlungsstruktur (28', 28"') aus einem dielektrischen oder Halbleitermaterial mit eingebetteten Nanoteilchen, umfassend in Längsrichtung alternierende Nanoteilchen- und Nicht-Nanoteilchenbereiche, gebildet ist.

3. Nanoplasmonische Vorrichtung (10, 20) nach Anspruch 1, wobei das dielektrische oder Halbleitermaterial (32) der Kühlungsstruktur (28', 28") aus einem dielektrischen oder Halbleitermaterial mit eingebetteten Nanoteilchen, hergestellt aus einem Oxid wie Siliziumdioxid, Titandioxid oder Tantalpentoxid, gebildet ist.

4. Nanoplasmonische Vorrichtung (10, 20) nach Anspruch 1, wobei die Nanoteilchen (34) der Kühlungsstruktur (28', 28") aus einem dielektrischen oder Halbleitermaterial mit eingebetteten Nanoteilchen, hergestellt aus Gold, Silber, Aluminium, Platin oder Kupfer, gebildet sind, um Oberflächenplasmonresonanzen zu tragen, oder aus SiC, kubischem Bornitrid, hexagonalem Bornitrid oder Borcarbid hergestellt sind, um Oberflächenphononresonanzen zu tragen.

5. Nanoplasmonische Vorrichtung (10, 20) nach Anspruch 1, wobei die Schicht (38), die die Oberflächenphononresonanzen oder Oberflächenplasmonresonanzen trägt, Teil eines Stapels (38, 40, 42, 44) ist, der Oberflächenplasmonresonanzen oder Oberflächenphononresonanzen trägt.

6. Nanoplasmonische Vorrichtung (10, 20) nach Anspruch 5, wobei die Schichten des Stapels (38, 40, 42, 44) aus einem Oberflächenplasmonresonanz-tragendem Metall oder aus einem Phononresonanz-tragendem Material hergestellt sind, und wobei die Schichten durch dielektrische Schichten getrennt sind.

7. Nanoplasmonische Vorrichtung nach Anspruch 6, wobei das Oberflächenplasmonresonanz-tragende Metall aus Gold oder Silber ausgewählt ist, und/oder das Phononresonanz-tragende Material aus SiC, kubischem Bornitrid, hexagonalem Bornitrid oder Borcarbid ausgewählt ist.

8. Nanoplasmonische Vorrichtung nach einem der Ansprüche 1 bis 7, wobei die Dicke der erwärmbaren Schicht (22) innerhalb des Bereichs zwischen 5 nm und 30 nm ist.

9. Nanoplasmonische Vorrichtung nach einem der Ansprüche 1 bis 8, wobei die Dicke der Kühlungsstruktur (28, 28') innerhalb des Bereichs zwischen 5 nm und 200 nm ist.

10. Nanoplasmonische Vorrichtung nach Anspruch 1, umfassend plasmonische Kühlungsschicht, und wobei die plasmonische Kühlungsschicht eine Spaltschicht von weniger als einer Unterwellenlängendicke und eine plasmonische Unterschicht umfasst, oder umfassend eine phononische Kühlungsschicht und die phononische Kühlungsschicht umfasst eine Spaltschicht von weniger als einer Unterwellenlängendicke und eine plasmonische Unterschicht.

11. Nanoplasmonische Vorrichtung nach Anspruch 10, wobei die plasmonische Kühlungsschicht alternierende Spaltschichten und plasmonische Unterschichten umfasst, oder wobei die phononische Kühlungsschicht alternierende Spaltschichten und phononische Unterschichten umfasst.

12. Nanoplasmonische Vorrichtung nach Anspruch 1, wobei die Kühlungsstruktur eine phononische Kühlungsschicht umfasst und die phononische Kühlungsschicht in Längsrichtung alternierende Nanoteilchen- und Nicht-Nanoteilchenbereiche umfasst.

13. Nanoplasmonische Vorrichtung nach Anspruch 1, wobei die Kühlungsstruktur an den lokalisierten Energieaufnahmestellen lokalisiert ist.

14. Nanoplasmonische Vorrichtung nach Anspruch 1, wobei die Vorrichtung eine einer Datenspeichervorrichtung, einer Photovoltaikzelle und eines Lithographiemediums ist.

## Revendications

1. Dispositif nanoplasmonique (10, 20) formé sur un substrat (30), le dispositif nanoplasmonique comprenant :
une couche (22) apte à être chauffée nanoplasmoniquement ayant un côté chauffant (24) et un côté refroidissant (26), ladite couche apte à être chauffée comprenant une pluralité de sites récepteurs d'énergie localisés, chaque site récepteur d'énergie localisé étant approprié pour recevoir de l'énergie provenant de points de sous-longueur d'onde correspondants (16) d'un champ optique apte à être produit sur la couche apte à être chauffée (22) ; et
une structure refroidissante (28', 28") pour évacuer de la chaleur de ladite couche apte à être chauffée (22), ladite structure refroidissante étant située adjacente audit côté refroidissant (26) et étant prise en sandwich entre la couche (26) apte à être chauffée nanoplasmoniquement et le substrat (30),
**caractérisé par le fait que** :
la structure refroidissante (28', 28") est formée à partir d'un matériau diélectrique ou semi-conducteur (32) avec des nanoparticules noyées (34) qui supportent des résonances plasmoniques ou phononiques de surface, ou
la structure refroidissante (28', 28") comprend une structure multicouches comprenant l'un parmi un intervalle de vide, un intervalle d'air ou une couche diélectrique (36), l'intervalle ou la couche diélectrique étant disposé(e) au voisinage de la couche apte à être chauffée (22) pour faciliter un effet tunnel par phonons ou un couplage énergétique évanescent et
suivie par une couche (38) supportant des résonances phononiques de surface ou des résonances plasmoniques de surface.

2. Dispositif nanoplasmonique (10, 20) selon la revendication 1, dans lequel ladite structure refroidissante (28', 28") est formée à partir d'un matériau diélectrique ou semi-conducteur avec des nanoparticules noyées comprenant des régions de nanoparticules et de non-nanoparticules alternant longitudinalement.

3. Dispositif nanoplasmonique (10, 20) selon la revendication 1, dans lequel le matériau diélectrique ou semi-conducteur (32) de ladite structure refroidissante (28', 28") est formée à partir d'un matériau diélectrique ou semi-conducteur avec des nanoparticules noyées qui sont faites d'un oxyde tel que le dioxyde de silicium, le dioxyde de titane ou le pentoxyde de tantale.

4. Dispositif nanoplasmonique (10, 20) selon la revendication 1, dans lequel les nanoparticules (34) de ladite structure refroidissante (28', 28") sont formées à partir d'un matériau diélectrique ou semi-conducteur avec des nanoparticules noyées faites d'or, d'argent, d'aluminium, de platine ou de cuivre pour supporter des résonances plasmoniques de surface ou faites de SiC, de nitrure de bore cubique, de nitrure de bore hexagonal ou de carbure de bore pour supporter des résonances phononiques de surface.

5. Dispositif nanoplasmonique (10, 20) selon la revendication 1, dans lequel la couche (38) supportant des résonances phononiques de surface ou des résonances plasmoniques de surface fait partie d'un empilement (38, 40, 42, 44) supportant des résonances plasmoniques de surface ou des résonances phononiques de surface.

6. Dispositif nanoplasmonique (10, 20) selon la revendication 5, dans lequel les couches dudit empilement (38, 40, 42, 44) sont faites d'un métal supportant des résonances plasmoniques de surface, ou faites d'un matériau supportant des résonances phononiques, et lesdites couches sont séparées par des couches diélectriques.

7. Dispositif nanoplasmonique selon la revendication 6, dans lequel le métal supportant des résonances plasmoniques de surface est choisi parmi l'or ou l'argent, et/ou le matériau supportant des résonances phononiques est choisi parmi SiC, le nitrure de bore cubique, le nitrure de bore hexagonal ou le carbure de bore.

8. Dispositif nanoplasmonique selon l'une quelconque des revendications 1 à 7, dans lequel l'épaisseur de la couche apte à être chauffée (22) se situe dans la plage entre 5 nm et 30 nm.

9. Dispositif nanoplasmonique selon l'une quelconque des revendications 1 à 8, dans lequel l'épaisseur de la structure refroidissante (28, 28') se situe dans la plage entre 5 nm et 200 nm.

10. Dispositif nanoplasmonique selon la revendication 1, comprenant une couche refroidissante plasmonique et la couche refroidissante plasmonique comprend une couche d'intervalle de moins d'une épaisseur de sous-longueur d'onde et une sous-couche plasmonique, ou comprenant une couche refroidissante phononique et la couche refroidissante phononique comprend une couche d'intervalle de moins d'une épaisseur de sous-longueur d'onde et une sous-couche plasmonique.

11. Dispositif nanoplasmonique selon la revendication 10, dans lequel ladite couche refroidissante plasmonique comprend des couches d'intervalle et des sous-couches plasmoniques alternées, ou ladite couche refroidissante phononique comprend des couches d'intervalle et des sous-couches phononiques alternées.

12. Dispositif nanoplasmonique selon la revendication 1, dans lequel ladite structure refroidissante comprend une couche refroidissante phononique et la couche refroidissante phononique comprend des régions de nanoparticules et de non-nanoparticules alternant longitudinalement.

13. Dispositif nanoplasmonique selon la revendication 1, dans lequel ladite structure refroidissante est localisée sur lesdits sites récepteurs d'énergie localisés.

14. Dispositif nanoplasmonique selon la revendication 1, dans lequel ledit dispositif est l'un parmi un dispositif de stockage de données, une cellule photovoltaïque et un support de lithographie.
